# EUROPÄISCHE PATENTSCHRIFT

(11) **EP 1 649 498 B1**
(45) Veröffentlichungstag und Bekanntmachung des Hinweises auf die Patenterteilung: **29.04.2015**
(21) Anmeldenummer: 04762444.0
(22) Anmeldetag: 22.07.2004
(51) Int. Cl.: H01L 21/02, H01L 21/20, H01L 33/00

(54) **VERFAHREN ZUR HERSTELLUNG EINER VIELZAHL VON OPTOELEKTRONISCHEN HALBLEITERCHIPS UND OPTOELEKTRONISCHER HALBLEITERCHIP**
METHOD FOR THE PRODUCTION OF A PLURALITY OF OPTO-ELECTRONIC SEMICONDUCTOR CHIPS AND OPTO-ELECTRONIC SEMICONDUCTOR CHIP
PROCEDE DE FABRICATION D'UNE PLURALITE DE PUCES A SEMI-CONDUCTEUR OPTOELECTRONIQUES ET PUCE A SEMI-CONDUCTEUR OPTOELECTRONIQUE AINSI OBTENUE

(30) Priorität: 31.07.2003 DE 10335081
(43) Veröffentlichungstag der Anmeldung: 26.04.2006
(73) Patentinhaber: OSRAM Opto Semiconductors GmbH, 93055 Regensburg (DE)
(72) Erfinder: HÄRLE, Volker, 93164 Waldetzenberg (DE)
(74) Vertreter: Epping - Hermann - Fischer
(86) Internationale Anmeldenummer: PCT/DE2004/001594
(87) Internationale Veröffentlichungsnummer: WO 2005/013316

(56) Entgegenhaltungen:
- EP-A1- 0 388 733
- EP-A2- 0 472 221
- EP-A2- 1 005 067
- US-A- 6 110 277
- YANG J W ET AL: "Selective area deposited blue GaN–InGaN multiple-quantum well light emitting diodes over silicon substrates" APPLIED PHYSICS LETTERS, AMERICAN INSTITUTE OF PHYSICS. NEW YORK, US, Bd. 76, Nr. 3, 17. Januar 2000 (2000-01-17), Seiten 273-275, XP012025677 ISSN: 0003-6951
- MIYATA NORIYUKI ET AL: "Selective growth of nanocrystalline Si dots using an ultrathin-Si-oxide/oxynitride mask" APPLIED PHYSICS LETTERS, AMERICAN INSTITUTE OF PHYSICS. NEW YORK, US, Bd. 77, Nr. 11, 11. September 2000 (2000-09-11), Seiten 1620-1622, XP012026105 ISSN: 0003-6951
- PATENT ABSTRACTS OF JAPAN Bd. 017, Nr. 676 (E-1475), 13. Dezember 1993 (1993-12-13) -& JP 05 226781 A (FUJITSU LTD), 3. September 1993 (1993-09-03)

## Beschreibung

Die Erfindung betrifft ein Verfahren zur Herstellung einer Vielzahl optoelektronischer Halbleiterchips, die jeweils eine Vielzahl von Strukturelementen mit jeweils mindestens einer Halbleiterschicht aufweisen. Halbleiterschichten der Strukturelemente werden dabei mittels selektiver Epitaxie aufgewachsen. Zudem betrifft die Erfindung einen nach diesem Verfahren hergestellten optoelektronischen Halbleiterchip.

Ein derartiger optoelektronischer Halbleiterchip sowie ein entsprechendes Verfahren zu dessen Herstellung ist beispielsweise in der DE 199 11 717 A1 beschrieben. Dieser weist eine Vielzahl von Strahlungsauskoppelelementen auf, die z. B. eine epitaktisch gewachsene Halbleiterschichtfolge mit einer elektromagnetische Strahlung erzeugenden aktiven Schicht umfassen. Dadurch weist dieses Bauelement eine verbesserte Strahlungsauskopplung auf.

Eines der angegebenen Verfahren zur Herstellung der Strahlungsauskoppelelemente beinhaltet selektive Epitaxie. Dabei wird zunächst eine durchgehende Maskenschicht aufgebracht, in die nachfolgend mittels Fotolithographie und Ätzen Fenster eingebracht werden. In die Fenster werden Halbleiterschichtenfolgen selektiv abgeschieden und die Maskenschicht nachfolgend mittels Ätzen wieder entfernt.

Ein solches Verfahren hat den Nachteil, neben dem Aufwachsen einer Maskenschicht auch die relativ aufwendigen Verfahrensschritte der Fotolithographie und des Ätzens zu umfassen, die üblicherweise in einer separaten Anlage durchgeführt werden müssen.

In der Druckschrift J. W. Yang et al., "Selective Area deposited blue GaN-InGaN multiple-quantum well light emitting diodes over silicon substrates", Applied Physics Letters, Bd. 76, Nr. 3 (17.01.2000), S. 273-275, XP-120025677, wird ein Verfahren beschrieben, bei dem lichtemittierende Halbleiterchips selektiv in fotolithografisch hergestellten Öffnungen einer SiO₂-Maskenschicht aufgewachsen werden.

In der Druckschrift Noriyuki Miyata et al., "Selective growth of nanocrystalline Si dots using an ultrathin-Sioxide/oxynitride mask" wird ein Verfahren beschrieben, bei dem in einer Maskenmaterialschicht nach dem Aufwachsen durch einen gebündelten Elektronenstrahl Fenster erzeugt werden, in denen anschließend nanokristalline Silizium-Dots aufgewachsen werden.

Der vorliegenden Erfindung liegt die Aufgabe zugrunde, ein einfacheres und kostengünstigeres Verfahren zur Herstellung von optoelektronischen Halbleiterchips der eingangs genannten Art bereitzustellen. Eine weitere Aufgabe der vorliegenden Erfindung ist das Bereitstellen eines nach einem derartigen Verfahren hergestellten Halbleiterchips.

Diese Aufgaben werden durch ein Herstellungsverfahren mit den Merkmalen von Anspruch 1 bzw. durch einen optoelektronischen Halbleiterchip mit den Merkmalen von Anspruch 18 gelöst. Vorteilhafte Weiterbildungen des Verfahrens sind Gegenstand der Ansprüche 2 bis 17.

Erfindungsgemäß beinhaltet das Verfahren zur Herstellung einer Vielzahl von optoelektronischen Halbleiterchips der eingangs genannten Art zumindest die folgenden Verfahrensschritte:
Bereitstellen einer Chipverbund-Basis, die ein Substrat sowie eine Aufwachsoberfläche aufweist;
Aufwachsen einer nicht geschlossenen Maskenmaterialschicht auf die Aufwachsoberfläche, derart, dass die
Maskenmaterialschicht eine Vielzahl statistisch verteilter Fenster mit variierenden Formen und/oder Öffnungsflächen aufweist, wobei ein Maskenmaterial derart gewählt wird, dass sich ein in einem späteren Verfahrensschritt aufzuwachsendes Halbleitermaterial der Halbleiterschicht auf diesem im Wesentlichen nicht oder im Vergleich zur Aufwachsoberfläche wesentlich schlechter aufwachsen lässt;
im Wesentlichen gleichzeitiges Aufwachsen von Halbleiterschichten auf innerhalb der Fenster liegenden Bereichen der Aufwachsoberfläche; und
Vereinzeln der Chipverbund-Basis mit aufgebrachtem Material zu Halbleiterchips, die jeweils eine Vielzahl von Strukturelementen mit jeweils mindestens einer Halbleiterschicht aufweisen.

Das Herstellen der Maskenmaterialschicht mit Fensteröffnungen kann demnach vorteilhafterweise mittels einem einzigen Verfahrensschritt erfolgen. Zweckmäßigerweise erfolgt das Aufwachsen der Maskenmaterialschicht in situ in einer Anlage, in der auch Halbleiterschichten des Bauelements aufgewachsen werden.

Bevorzugt weist die Chipverbund-Basis zumindest eine epitaktisch auf das Substrat aufgewachsene Halbleiterschicht auf. Die Aufwachsoberfläche ist dabei eine Oberfläche auf der dem Substrat abgewandten Seite der epitaktisch gewachsenen Halbleiterschicht.

Das erfindungsgemäße Verfahren eignet sich dabei, sowohl beliebige Halbleiterschichten der Chipverbund-Basis als auch die Maskenschicht und Halbleiterschichten der Strukturelemente ohne Einschränkungen in einem einzigen Reaktor herzustellen.

Die Chipverbund-Basis weist in einer vorteilhaften Ausführungsform des Verfahrens eine epitaktisch auf das Substrat aufgewachsene Halbleiterschichtfolge auf, die eine elektromagnetische Strahlung emittierende aktive Zone umfasst. Entsprechend ist die Aufwachsoberfläche eine Oberfläche auf der dem Substrat abgewandten Seite der Halbleiterschichtenfolge. Die nachfolgend auf die Aufwachsoberfläche aufgebrachten Halbleiterschichten der Strukturelemente bilden eine Strukturierung, die beispielsweise den Zweck einer verbesserten Auskopplung der in der Chipverbund-Basis erzeugten elektromagnetischen Strahlung erfüllt.

Alternativ oder zusätzlich weisen die Strukturelemente jeweils eine epitaktisch gewachsene Halbleiterschichtfolge mit einer aktiven Zone auf, die elektromagnetische Strahlung emittiert.

Bevorzugte Materialien für die Maskenmaterialschicht weisen SiO₂, SiₓN_{y} oder Al₂O₃ auf.

Nach dem Aufwachsen der Halbleiterschichten der Strukturelemente wird auf diese bevorzugt eine Schicht aus elektrisch leitendem Kontaktmaterial aufgebracht, das für eine von der aktiven Zone emittierte elektromagnetische Strahlung durchlässig ist, so dass Halbleiterschichten mehrerer Strukturelemente durch das Kontaktmaterial elektrisch leitend miteinander verbunden werden. Dadurch lassen sich elektrische Kontaktstrukturen bilden, durch die ein geringer Anteil an in dem Bauelement erzeugter elektromagnetischer Strahlung absorbiert wird.

Die durchschnittliche Dicke der Maskenmaterialschicht ist bevorzugt geringer als die summierte Dicke der Halbleiterschichten eines Strukturelementes, wodurch sich Strukturelemente mit vorteilhaften Formen erzeugen lassen. In einer Ausführungsform des Verfahrens wird die Maskenmaterialschicht nach dem Aufwachsen der Halbleiterschichten zweckmäßigerweise zumindest teilweise entfernt.

In einer weiteren Ausführungsform des Verfahrens wird nach dem Aufwachsen der Halbleiterschichtenfolgen mit Vorteil alternativ oder zusätzlich zum Entfernen von Maskenmaterial eine Planarisierungsschicht über der Aufwachsoberfläche aufgebracht. Diese kann insbesondere dann zu einer verbesserten Lichtauskopplung führen, wenn für sie ein Material gewählt wird, dessen Brechungsindex kleiner ist als derjenige von angrenzenden Halbleiterschichten.

Die Planarisierungsschicht weist bevorzugt ein Material auf, das dielektrische Eigenschaften hat.

Das Verfahren bietet die Möglichkeit zur Herstellung von ganz unterschiedlich strukturierten Maskenmaterialschichten mit jeweils unterschiedlich großen und unterschiedlich geformten Fenstern in diesen. Beispielsweise können die Aufwachsbedingungen zum Aufwachsen der Maskenmaterialschicht mit Vorteil derart eingestellt werden, dass dreidimensionales Wachstum überwiegt und die Maskenmaterialschicht überwiegend aus einer Vielzahl dreidimensional wachsender Kristallite gebildet wird.

Alternativ werden die Aufwachsbedingungen zum Aufwachsen der Maskenmaterialschicht mit Vorteil derart eingestellt, dass zweidimensionales Wachstum überwiegt und die Maskenmaterialschicht überwiegend aus einer Vielzahl zweidimensional zusammenwachsender Teilschichten gebildet wird.

Es ist beim Aufwachsen der Maskenmaterialschicht und der Halbleiterschichten der Strukturelemente ebenso mit Vorteil vorgesehen, die Aufwachsbedingungen während des Aufwachsens zu variieren, so dass beispielsweise zu Beginn des Aufwachsens dreidimensionales Wachstum und nachfolgend zweidimensionales Wachstum überwiegt.

Bevorzugt werden die Aufwachsbedingungen zum Aufwachsen der Maskenmaterialschicht derart eingestellt, dass die meisten der Fenster mit einer mittleren Ausbreitung in der Größenordnung von Mikrometern gebildet werden. Alternativ ist es möglich, die meisten der Fenster mit einer mittleren Ausdehnung von kleiner als oder gleich 1 µm herzustellen.

Unter Ausbreitung ist in diesem Zusammenhang die Länge eines auf eine Gerade projizierten Fensters zu verstehen, wobei die Gerade in einer Haupterstreckungsebene der Maskenmaterialschicht verläuft. Die mittlere Ausbreitung ist demnach die über alle Richtungen gemittelte Ausbreitung eines Fensters.

Mit dem Einstellen der Wachstumsbedingungen lassen sich beim Aufwachsen der Maskenmaterialschicht nicht nur die Form oder die Größe der Fenster variieren, sondern es lässt sich beispielsweise auch mit Vorteil die Flächendichte einstellen, mit der die Fenster auf der Aufwachsoberfläche erzeugt werden.

Beim Aufwachsen der Halbleiterschichten der Strukturelemente werden die Aufwachsbedingungen bevorzugt derart eingestellt und alternativ oder zusätzlich während des Aufwachsens variiert, dass die Halbleiterschichten mit einer für die Auskopplung von elektromagnetischer Strahlung vorteilhaften Form, beispielsweise einer zumindest näherungsweise linsenartigen Form gebildet werden.

Das Aufwachsen der Maskenmaterialschicht und der Halbleiterschichten erfolgt besonders bevorzugt mittels Metallorganischer Gasphasenepitaxie (MOVPE).

Der optoelektronische Halbleiterchip zeichnet sich dadurch aus, dass er nach dem erfindungsgemäßen Verfahren oder einer Ausführungsform von diesem hergestellt ist. Insbesondere umfasst der optoelektronische Halbleiterchip ein Substrat und eine Aufwachsoberfläche mit einer Maskenmaterialschicht, wobei die Maskenmaterialschicht eine Vielzahl statistisch verteilter Fenster mit variierenden Formen und/oder Öffnungsflächen aufweist. Der Halbleiterchip weist eine Vielzahl von nebeneinander angeordneten Strukturelementen auf, die auf innerhalb der Fenster liegenden Bereichen der Aufwachsoberfläche angeordnet sind, wobei die Strukturelemente jeweils durch eine Halbleiterschichtenfolge gebildet sind, die eine elektromagnetische Strahlung emittierende aktive Zone aufweist.

Weitere Vorteile, bevorzugte Ausführungsformen und Weiterbildungen des Verfahrens bzw. des optoelektronischen Halbleiterchips ergeben sich aus den im folgenden in Verbindung mit den Figuren 1a bis 3 erläuterten Ausführungsbeispielen. Es zeigen:
Figuren 1a bis 1d eine schematische Draufsicht auf einen Ausschnitt einer Aufwachsoberfläche während verschiedenen Stadien eines Ausführungsbeispiels des Verfahrens,
Figur 2 eine schematische Schnittansicht eines Ausschnittes eines ersten Ausführungsbeispieles des optoelektronischen Bauelements und
Figur 3 eine schematische Schnittansicht eines Ausschnittes eines zweiten Ausführungsbeispieles des optoelektronischen Bauelements.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

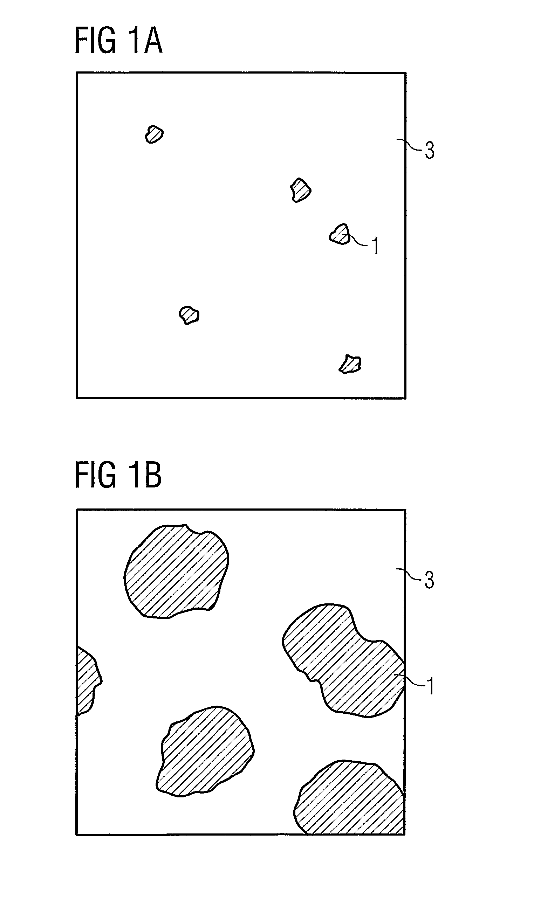

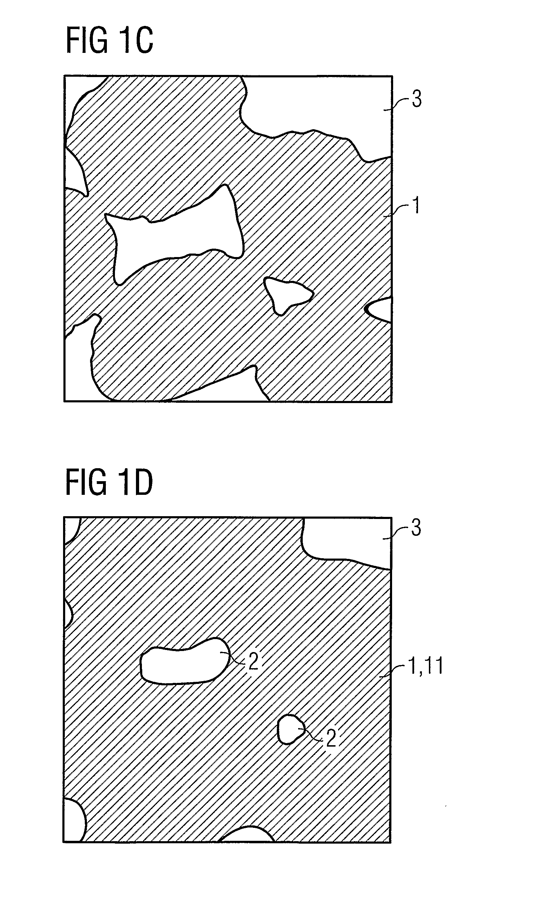

In den Figuren 1a bis 1d ist in chronologischer Abfolge jeweils ein Ausschnitt einer Aufwachsoberfläche 3 während des Aufwachsens einer Maskenmaterialschicht 11 aus einem Maskenmaterial 1 gezeigt. Die Aufwachsoberfläche 3 kann beispielsweise eine Fläche eines Substrates aus n-GaAs sein, das Maskenmaterial 1 besteht z.B. aus SiₓN_{y}.

Das Wachstum des Maskenmaterials 1 beginnt an vereinzelten Punkten der Aufwachsoberfläche 3, an denen sich Kristallite aus Maskenmaterial 1 bilden. Die Kristallite aus Maskenmaterial 1 wachsen im weiteren Verlauf lateral zusammen (siehe Figuren 1b bis 1d), wobei die Wachstumsbedingungen beispielsweise derart eingestellt werden können, dass zweidimensionales Wachstum überwiegt, d.h., dass die Kristallite aus Maskenmaterial 1 überwiegend in einer Ebene parallel zur Aufwachsoberfläche wachsen und nur in geringerem Maße senkrecht dazu. Alternativ kann durch entsprechendes Einstellen der Wachstumsbedingungen auch überwiegend dreidimensionales Wachstum der Kristallite erreicht werden, d.h. ein Wachstum, bei dem die Wachstumsrate in allen möglichen Wachstumsrichtungen ähnlich groß bzw. von einer gleichen Größenordnung ist.

Unter Wachstumsbedingungen sind dabei von außen einstellbare, kontrollierbare bzw. änderbare Parameter wie z.B. Druck, Temperatur, Materialfluß und Wachstumsdauer im Epitaxiereaktor zu verstehen. Die genauen Werte für derartige Parameter zur Erzielung einer bestimmten Aufwachs-Charakteristik können stark variieren und hängen beispielsweise von der Aufteilung und den geometrischen Abmessungen des Epitaxiereaktors oder von dem aufzuwachsenden Material ab.

Die Herstellung einer nicht geschlossenen SiₓN_{y}-Schicht erfolgt beispielsweise in einem MOVPE-Reaktor durch Zuschalten von SiH₄ und NH₃ bei geeigneter Reaktortemperatur, die typischerweise in einem Bereich zwischen 500 und 1100°C liegen kann. Die Reaktortemperatur kann aber auch oberhalb oder unterhalb dieses Bereichs liegen. Solche Verfahren sind etwa in Hageman, P. R. et al, phys. stat. sol. (a) 188, No. 2 (2001), 659-662 beschrieben, dessen Inhalt insofern hiermit durch Rückbezug aufgenommen wird. Alternativ kann als Si-Quelle auch Tetraethyl-Silizium (Si(C₂H₅)₄) oder eine ähnliche Si-haltige Verbindung, die sich für die Epitaxie eignet, verwendet werden.

Bei dem in Figur 1d gezeigten Stadium des Aufwachsens ist die Maskenmaterialschicht 11 fertig ausgebildet. Sie weist eine Vielzahl statistisch verteilter Fenster 2 mit variierenden Formen und Öffnungsflächen auf. Die Abscheidebedingungen werden beispielsweise so gewählt, dass die meisten der Fenster eine mittlere Ausdehnung in der Größenordnung von Mikrometern aufweisen. Alternativ können die meisten der Fenster auch eine mittlere Ausdehnung von kleiner als 1 µm aufweisen. Dadurch können mehr und kleinere Strukturelemente erzeugt und z.B. eine verbesserte Strahlungsauskopplung aus den Bauelementstrukturen erreicht werden.

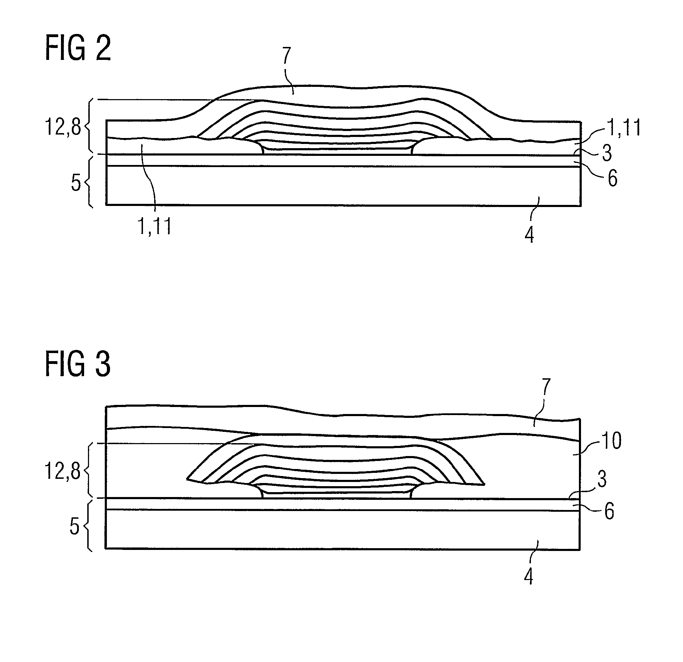

Auf innerhalb dieser Fenster 2 liegenden Bereichen der Aufwachsoberfläche 3 werden nachfolgend beispielsweise Halbleiterschichtfolgen 8 selektiv abgeschieden (siehe Figur 2 oder 3). Diese können etwa auf Phosphid-Verbindungshalbleitern basierend sein und vorzugsweise Materialien InₙGamAl₁₋ₙ₋ₘP aufweisen, wobei 0 ≤ n ≤ 1, 0 ≤ m ≤ 1 und n+m ≤ 1. Dabei können diese Materialien ein oder mehrere Dotierstoffe sowie zusätzliche Bestandteile aufweisen, die die physikalischen Eigenschaften des Materials im Wesentlichen nicht ändern.

Eine Halbleiterschichtfolge 8 bildet ein Strukturelement 12. Im Sinne der Erfindung ist es dabei auch möglich, dass Halbleiterschichten mehrerer Strukturelemente überlappen bzw. dass mehrere Strukturelemente zumindest eine gemeinsame Halbleiterschicht aufweisen. Dies ist beispielsweise der Fall, wenn Halbleiterschichtenfolgen 8 so weit lateral über die Maskenmaterialschicht wachsen, dass Halbleiterschichten benachbarter Strukturelemente 12 teilweise oder ganz zusammenwachsen. In derartigen Fällen verläuft eine Grenze zwischen zwei benachbarten Strukturelementen entlang einer Linie, entlang der auf der Maskenmaterialschicht befindliches Halbleitermaterial eine minimale Dicke aufweist.

In Figur 2 weist die das Strukturelement 12 bildende Halbleiterschichtfolge 8 eine aktive Zone auf, die bei Beaufschlagung mit Strom elektromagnetische Strahlung emittiert. Ein Strukturelement 12 kann jedoch auch keine aktive Zone aufweisen und z.B. aus nur einer Halbleiterschicht gebildet sein, die eine linsenartige Form aufweist.

Die aktive Zone kann einen herkömmlichen pn-Übergang aufweisen, beispielsweise für eine Lumineszenzdiode. Solche Strukturen sind dem Fachmann bekannt und werden von daher an dieser Stelle nicht näher erläutert.

Dadurch, dass die Fenster unterschiedlich große Öffnungsflächen aufweisen, ergeben sich für die darin abgeschiedenen Schichten der Halbleiterschichtfolgen 8 unterschiedliche Materialzusammensetzungen. Bei elektromagnetische Strahlung emittierenden Strukturen ergeben sich somit unterschiedliche Emissionsspektren, so dass sich mit derartigen strahlungsemittierenden Bauelementen insgesamt ein breiteres Emissionsspektrum erreichen lässt als mit herkömmlichen Bauelementen.

In Figur 2 ist eine schematische Schnittansicht eines Ausschnittes eines mit dem Verfahren hergestellten optoelektronischen Bauelementes gezeigt. Die Chipverbund-Basis 5 umfasst ein Substrat 4 sowie eine auf diesem Substrat epitaktisch aufgewachsene Halbleiterschicht oder Halbleiterschichtfolge 6, deren von dem Substrat 4 abgewandte Seite die Aufwachsoberfläche 3 bildet. Auf der Aufwachsoberfläche 3 ist eine Maskenmaterialschicht 11 aufgewachsen, die in dem gezeigten Ausschnitt des Bauelementes ein Fenster aufweist, in das eine Halbleiterschichtfolge 8 selektiv abgeschieden ist.

Die maximale Dicke der Maskenmaterialschicht 11 kann z.B. nur einige nm betragen und ist geringer als die Höhe der Halbleiterschichtfolge 8. Dadurch werden Halbleiterschichten der Halbleiterschichtfolge 8 ab einer Höhe, die größer ist als die Dicke der sie umgebenden Maskenmaterialschicht 11, durch laterales Wachstum auch teilweise über der Maskenmaterialschicht 11 aufgewachsen.

Die Aufwachsbedingungen zum Aufwachsen der Halbleiterschichtfolge 8 werden z.B. derart gewählt oder während des Aufwachsens variiert, dass die Halbleiterschichtfolge 8 mit einer linsenartigen Form gebildet werden. Alternativ kann diese Form auch kegelstumpfartig oder polyederartig sein.

Der Begriff Aufwachsbedingungen ist in diesem Zusammenhang ähnlich zu verstehen wie beim vorhergehend erläuterten Aufwachsen von Maskenmaterial 1. Dabei hängt es neben der Art des aufzuwachsenden Halbleitermaterials und der Art der Epitaxieanlage auch stark von der Art des Maskenmaterials 1 ab, wie genau sich das Einstellen bestimmter Werte für Parameter wie Druck, Temperatur, Materialfluß und Wachstumsdauer auf das Wachstum von Halbleitermaterialien auswirkt.

Bei dem in Figur 2 dargestellten Ausführungsbeispiel überdeckt die zuletzt aufgewachsene Halbleiterschicht alle übrigen Halbleiterschichten der Halbleiterschichtenfolge 8. Dies ermöglicht es, eine Schicht aus elektrisch leitfähigem Kontaktmaterial 7 beispielsweise flächig über der gesamten Aufwachsoberfläche 3 bzw. auf der Halbleiterschichtfolge 8 und dem Maskenmaterial 1 aufzubringen, ohne dass verschiedene Halbleiterschichten der Halbleiterschichtfolge 8 elektrisch kurzgeschlossen werden. Als Kontaktmaterial 7 eignet sich beispielsweise Indiumzinnoxid (ITO) oder auch eine wenige Atomlagen dicke Metallschicht, beispielsweise aus Platin, die durch ihre geringe Dicke für eine von der aktiven Zone der Halbleiterschichtfolge 8 emittierte Strahlung durchlässig ist.

Ein Kontaktmaterial mit ITO kann zusätzlich eine derartige dünne Metallschicht aufweisen, die vor dem ITO abgeschieden wird. Dadurch kann die elektrische Leitfähigkeit des Kontaktes zwischen Kontaktmaterial 7 und Halbleiterschichtfolge 8 verbessert werden.

Damit sich zwischen dem Kontaktmaterial 7 und der Halbleiterschichtfolge 8 ein elektrisch leitender Kontakt ausbildet, muss das Bauelement nach Aufbringen des Kontaktmaterials 7 in der Regel bei einer geeigneten Temperatur ausreichend lang getempert werden. Diese Maßnahmen sind dem Fachmann bekannt und werden von daher nicht näher erläutert.

Auf das Kontaktmaterial 7 kann vor oder nach dem Tempern ein Bondpad aufgebracht werden, über das die Halbleiterschichtfolge von einer Seite her z.B. mittels eines Bonddrahts kontaktiert werden kann (nicht gezeigt).

Wenn das Substrat 4 rückseitig, d.h. auf der von der Aufwachsoberfläche abgewandten Seite, mit einem Kontaktmaterial versehen und elektrisch leitend verbunden ist, dann kann man über das Bondpad und den Rückseitenkontakt direkt an die noch im Verbund befindlichen Bauelemente eine Spannung anlegen und ihre Funktionsfähigkeit testen (Direct Probing).

Bei dem Bauelement des in Figur 2 gezeigten Ausschnittes kann alternativ oder zusätzlich auch die auf dem Substrat 4 angeordnete Halbleiterschichtfolge 6 eine elektromagnetische Strahlung emittierende, aktive Zone aufweisen. Bei Anlegen einer Spannung an das Bauelement wird der Strom durch die Maskenmaterialschicht 11 auf einen Bereich der Fenster 2 beschränkt, so dass ein Lichterzeugungsbereich im Wesentlichen auf einen Teil der aktiven Zone der Halbleiterschichtfolge 6 beschränkt ist, der unterhalb eines Fensters 2 liegt.

In Figur 3 ist der Ausschnitt eines zweiten Ausführungsbeispieles des Bauelements gezeigt. Im Unterschied zu dem anhand Figur 2 erläuterten Ausführungsbeispiel beinhaltet das Verfahren zur Herstellung in diesem Beispiel nach dem Aufbringen der Halbleiterschichtfolge 8 ein Entfernen der Maskenmaterialsschicht 11, was durch selektives Ätzen erfolgen kann.

Nachfolgend wird auf die Aufwachsoberfläche 3 und die Halbleiterschichtfolge 8 eine Planarisierungsschicht 10 aufgebracht, die z.B. aus einem Dielektrikum bestehen kann, dessen Brechungsindex kleiner ist als der von Materialien der Halbleiterschichtfolge 8.

Damit die Halbleiterschichtfolge 8 elektrisch leitend kontaktiert werden kann, wird die Planarisierungsschicht 10 im Folgenden zumindest teilweise abgedünnt oder entfernt, so dass die äußerste Schicht der Halbleiterschichtfolge 8 freigelegt wird. Auf diese wird nachfolgend analog dem anhand Figur 2 erläuterten Ausführungsbeispiel elektrisch leitendes Kontaktmaterial 7 aufgebracht und getempert.

Nachfolgend kann die Chipverbund-Basis 5 mit dem aufgebrachten Material zu einer Vielzahl optoelektronischer Halbleiterchips vereinzelt werden. Jeder dieser Halbleiterchips umfasst eine Vielzahl von nebeneinander angeordneten Strukturelementen 12.

Der Schutzumfang der Erfindung ist nicht durch die Beschreibung der Erfindung anhand der Ausführungsbeispiele beschränkt. Beispielsweise lassen sich die Fenster in der Maskenmaterialschicht derart klein ausbilden, dass in ihnen quasi eindimensionale Halbleiterbauelement-Strukturen aufgewachsen werden.

## Patentansprüche

1. Verfahren zur Herstellung einer Vielzahl von optoelektronischen Halbleiterchips, wobei das Verfahren zumindest die folgenden Verfahrensschritte umfasst:
- Bereitstellen einer Chipverbund-Basis, die ein Substrat sowie eine Aufwachsoberfläche aufweist;
- Aufwachsen einer Maskenmaterialschicht auf die Aufwachsoberfläche, derart, dass die Maskenmaterialschicht eine Vielzahl von Fenstern aufweist, wobei ein Maskenmaterial derart gewählt wird, dass sich ein in einem späteren Verfahrensschritt aufzuwachsendes Halbleitermaterial der Halbleiterschicht auf diesem im Wesentlichen nicht oder im Vergleich zur Aufwachsoberfläche wesentlich schlechter aufwachsen lässt;
- im Wesentlichen gleichzeitiges Aufwachsen von Halbleiterschichten auf innerhalb der Fenster liegenden Bereichen der Aufwachsoberfläche; und
- Vereinzeln der Chipverbund-Basis mit aufgebrachtem Material zu Halbleiterchips, wobei
- die Halbleiterchips jeweils eine Vielzahl von Strukturelementen mit mindestens einer Halbleiterschicht aufweisen, **dadurch gekennzeichnet, dass**
- die Maskenmaterialschicht als nicht geschlosssene Schicht aufgewachsen wird, und
- die Vielzahl von Fenstern statistisch verteilt sind und variierende Formen und/oder Öffnungsflächen aufweisen.

2. Verfahren nach Anspruch 1, bei dem
die Chipverbund-Basis zumindest eine epitaktisch auf das Substrat aufgewachsene Halbleiterschicht aufweist und die Aufwachsoberfläche eine Oberfläche auf der dem Substrat abgewandten Seite der epitaktisch gewachsenen Halbleiterschicht ist.

3. Verfahren nach einem der vorhergehenden Ansprüche,
bei dem die Chipverbund-Basis eine epitaktisch auf das Substrat aufgewachsene Halbleiterschichtfolge mit einer elektromagnetische Strahlung emittierenden aktiven Zone aufweist und die Aufwachsoberfläche eine Oberfläche auf der dem Substrat abgewandten Seite der Halbleiterschichtenfolge ist.

4. Verfahren nach einem der Ansprüche 1 oder 2,
bei dem die Strukturelemente jeweils eine epitaktisch gewachsene Halbleiterschichtfolge mit einer elektromagnetische Strahlung emittierenden aktiven Zone aufweisen.

5. Verfahren nach einem der vorhergehenden Ansprüche,
bei dem das Maskenmaterial SiO₂, SiₓN_{y} oder Al₂O₃ aufweist.

6. Verfahren nach einem der vorhergehenden Ansprüche, bei dem nach dem Aufwachsen der Halbleiterschichten eine Schicht aus elektrisch leitendem Kontaktmaterial, das für eine von der aktiven Zone emittierte elektromagnetische Strahlung durchlässig ist, auf die Halbleiterschichten aufgebracht wird, so dass Halbleiterschichten mehrerer Strukturelemente durch das Kontaktmaterial elektrisch leitend miteinander verbunden werden.

7. Verfahren nach einem der vorhergehenden Ansprüche, bei dem die durchschnittliche Dicke der Maskenmaterialschicht geringer ist als die summierte Dicke der Halbleiterschichten eines Strukturelementes.

8. Verfahren nach einem der vorhergehenden Ansprüche, bei dem die Maskenmaterialschicht nach dem Aufwachsen der Halbleiterschichten zumindest teilweise entfernt wird.

9. Verfahren nach einem der vorhergehenden Ansprüche, bei dem nach dem Aufwachsen der Halbleiterschichtenfolgen eine Planarisierungsschicht über der Aufwachsoberfläche aufgebracht wird.

10. Verfahren nach Anspruch 9, bei dem
für die Planarisierungsschicht ein Material gewählt wird, dessen Brechungsindex kleiner ist als der der Halbleiterschichten.

11. Verfahren nach Anspruch 9 oder 10, bei dem
für die Planarisierungsschicht ein Material gewählt wird, das dielektrische Eigenschaften hat.

12. Verfahren nach einem der vorhergehenden Ansprüche,
bei dem die Aufwachsbedingungen zum Aufwachsen der Maskenmaterialschicht derart eingestellt werden, dass dreidimensionales Wachstum überwiegt und die Maskenmaterialschicht überwiegend aus einer Vielzahl dreidimensional wachsender Kristallite gebildet wird.

13. Verfahren nach einem der Ansprüche 1 bis 11,
bei dem die Aufwachsbedingungen zum Aufwachsen der Maskenmaterialschicht derart eingestellt werden, dass zweidimensionales Wachstum überwiegt und die Maskenmaterialschicht überwiegend aus einer Vielzahl zweidimensional zusammenwachsender Teilschichten gebildet wird.

14. Verfahren nach einem der vorhergehenden Ansprüche,
bei dem die Aufwachsbedingungen zum Aufwachsen der Maskenmaterialschicht derart eingestellt werden, dass die meisten der Fenster mit einer mittleren Ausbreitung in der Größenordnung von Mikrometern gebildet werden.

15. Verfahren nach einem der Ansprüche 1 bis 13,
bei dem die Aufwachsbedingungen zum Aufwachsen der Maskenmaterialschicht derart eingestellt werden, dass die meisten der Fenster mit einer mittleren Ausdehnung von kleiner als oder gleich 1 µm gebildet werden.

16. Verfahren nach einem der vorhergehenden Ansprüche,
bei dem die Aufwachsbedingungen zum Aufwachsen der Halbleiterschichten derart eingestellt und/oder während des Aufwachsens variiert werden, dass Halbleiterschichten der Strukturelemente zumindest näherungsweise eine linsenartige Form bilden.

17. Verfahren nach einem der vorhergehenden Ansprüche,
bei dem das Aufwachsen der Maskenmaterialschicht und der Halbleiterschichten mittels Metallorganischer Gasphasenepitaxie erfolgt.

18. Optoelektronischer Halbleiterchip, umfassend ein Substrat und eine Aufwachsoberfläche mit einer Maskenmaterialschicht,
wobei der Halbleiterchip eine Vielzahl von nebeneinander angeordneten Strukturelementen aufweist, die auf innerhalb der Fenster liegenden Bereichen der Aufwachsoberfläche angeordnet sind, wobei die Strukturelemente jeweils durch eine Halbleiterschichtenfolge gebildet sind, die eine elektromagnetische Strahlung emittierende aktive Zone aufweist,
**dadurch gekennzeichnet, dass**
die Maskenmaterialschicht eine Vielzahl statistisch verteilter Fenster mit variierenden Formen und/oder Öffnungsflächen aufweist.

## Claims

1. Method for the production of a plurality of optoelectronic semiconductor chips, the method comprising at least the following method steps:
- provision of a chip composite base having a substrate and a growth surface;
- growth of a mask material layer onto the growth surface in such a way that the mask material layer has a plurality of windows, a mask material being chosen in such a way that a semiconductor material of the semiconductor layer that is to be grown in a later method step essentially cannot grow on said mask material or can grow in a substantially worse manner in comparison with the growth surface;
- essentially simultaneous growth of semiconductor layers on regions of the growth surface that lie within the windows; and
- singulation of the chip composite base with applied material to form semiconductor chips, wherein
- the semiconductor chips respectively have a plurality of structural elements with at least one semiconductor layer,
**characterized in that**
- the mask material layer is grown as a non-closed layer, and
- the plurality of windows are statistically distributed and have varying forms and/or opening areas.

2. Method according to claim 1, in which the chip composite base has at least one semiconductor layer grown epitaxially onto the substrate and the growth surface is a surface on that side of the epitaxially grown semiconductor layer which is remote from the substrate.

3. Method according to one of the preceding claims, in which the chip composite base has a semiconductor layer sequence grown epitaxially onto the substrate with an active zone that emits electromagnetic radiation, and the growth surface is a surface on that side of the semiconductor layer sequence which is remote from the substrate.

4. Method according to either of claims 1 and 2, in which the structural elements respectively have an epitaxially grown semiconductor layer sequence with an active zone that emits electromagnetic radiation.

5. Method according to one of the preceding claims, in which the mask material has SiO₂, SiₓN_{y} or Al₂O₃.

6. Method according to one of the preceding claims, in which, after the growth of the semiconductor layers, a layer made of electrically conductive contact material that is transmissive to an electromagnetic radiation emitted by the active zone is applied to the semiconductor layers, so that semiconductor layers of a plurality of structural elements are electrically conductively connected to one another by the contact material.

7. Method according to one of the preceding claims, in which the average thickness of the mask material layer is less than the cumulated thickness of the semiconductor layers of a structural element.

8. Method according to one of the preceding claims, in which the mask material layer is at least partly removed after the growth of the semiconductor layers.

9. Method according to one of the preceding claims, in which, after the growth of the semiconductor layer sequences, a planarization layer is applied over the growth surface.

10. Method according to claim 9, in which a material whose refractive index is lower than that of the semiconductor layers is chosen for the planarization layer.

11. Method according to claim 9 or 10, in which a material which has dielectric properties is chosen for the planarization layer.

12. Method according to one of the preceding claims, in which the growth conditions for the growth of the mask material layer are set in such a way that three-dimensional growth is predominant and the mask material layer is predominantly formed from a plurality of three-dimensionally growing crystallites.

13. Method according to one of claims 1 to 11, in which the growth conditions for the growth of the mask material layer are set in such a way that two-dimensional growth is predominant and the mask material layer is predominantly formed from a plurality of two-dimensionally accreting partial layers.

14. Method according to one of the preceding claims, in which the growth conditions for the growth of the mask material layer are set in such a way that most of the windows are formed with an average extent of the order of magnitude of micrometers.

15. Method according to one of claims 1 to 13, in which the growth conditions for the growth of the mask material layer are set in such a way that most of the windows are formed with an average extent of less than or equal to 1 µm.

16. Method according to one of the preceding claims, in which the growth conditions for the growth of the semiconductor layers are set and/or varied during growth in such a way that semiconductor layers of the structural elements at least approximately form a lenslike form.

17. Method according to one of the preceding claims, in which the mask material layer and the semiconductor layers are grown by means of metal organic vapor phase epitaxy.

18. Optoelectronic semiconductor chip, comprising a substrate and a growth surface having a mask material layer,
wherein the semiconductor chip has a plurality of structural elements arranged alongside one another which are arranged on regions of the growth surface that lie within the windows, wherein the structural elements are respectively formed by a semiconductor layer sequence which has an active zone that emits electromagnetic radiation,
**characterized in that**
the mask material layer has a plurality of statistically distributed windows having varying forms and/or opening areas.

## Revendications

1. Procédé pour la fabrication d'une pluralité de puces optoélectroniques à semi-conducteur, le procédé comprenant au moins les étapes de processus suivantes:
- disposition d'une base-composite de puce qui comporte un substrat ainsi qu'une surface de croissance;
- croissance d'une couche de matériau de masque sur la surface de croissance, de sorte que la couche de matériau de masque présente plusieurs fenêtres, en choisissant le matériau de masque de manière que sur celle-ci un matériau semi-conducteur de la couche de semi-conducteur croissant dans une étape ultérieure de processus ne puisse pratiquement pas croître ou ne puisse croître que beaucoup moins bien en comparaison de la surface de croissance;
- croissance pratiquement simultanée de couches de semi-conducteur sur des zones de la surface de croissance qui se trouvent à l'intérieur des fenêtres; et
- isolement de la base-composite de puce avec le matériau appliqué, pour l'obtention de puces à semi-conducteur,
- les puces à semi-conducteur comportant chacune une pluralité d'éléments structuraux comportant au moins une couche de semi-conducteur,
**caractérisé en ce que**
- la couche de matériau de masque est formée par croissance sous forme de couche non continue et
- les plusieurs fenêtres sont réparties statistiquement et présentent des formes et/ou des surfaces d'ouvertures variables.

2. Procédé selon la revendication 1, dans lequel
la base-composite de couche comporte au moins une couche de semi-conducteur formée par croissance épitactique sur le substrat et la surface de croissance est une surface sur la face opposée au substrat de la couche de semi-conducteur formée par croissance épitactique.

3. Procédé selon l'une quelconque des revendications précédentes,
dans lequel la base-composite de couche présente une succession de couches de semi-conducteur formée par croissance épitactique sur le substrat, comportant une zone active émettant un rayonnement électromagnétique et la surface de croissance est une surface sur la face opposée au substrat de la succession de couches de semi-conducteur.

4. Procédé selon l'une quelconque des revendications 1 et 2,
dans lequel les éléments structuraux comportent chacun une succession de couches de semi-conducteur formée par croissance épitactique, comportant une zone active émettant un rayonnement électromagnétique.

5. Procédé selon l'une quelconque des revendications précédentes,
dans lequel le matériau de masque comporte SiO₂, SiₓN_{y} ou Al₂O₃.

6. Procédé selon l'une quelconque des revendications précédentes, dans lequel
après la croissance des couches de semi-conducteur on applique sur les couches de semi-conducteur une couche de matériau de contact conducteur de l'électricité, qui est transparente à un rayonnement électromagnétique émis par la zone active, de sorte que des couches de semi-conducteur de plusieurs éléments structuraux sont reliées entre elles par liaison conductrice de l'électricité par le matériau de contact.

7. Procédé selon l'une quelconque des revendications précédentes, dans lequel
l'épaisseur moyenne de la couche de matériau de masque est plus faible que la somme des épaisseurs des couches de semi-conducteur d'un élément structural.

8. Procédé selon l'une quelconque des revendications précédentes, dans lequel
après la croissance des couches de semi-conducteur on élimine au moins en partie la couche de matériau de masque.

9. Procédé selon l'une quelconque des revendications précédentes, dans lequel
après la croissance de la succession de couches de semi-conducteur on applique une couche de planarisation sur la surface de croissance.

10. Procédé selon la revendication 9, dans lequel
pour la couche de planarisation on choisit un matériau dont l'indice de réfraction est inférieur à celui des couches de semi-conducteur.

11. Procédé selon la revendication 9 ou 10, dans lequel
pour la couche de planarisation on choisit un matériau qui a des propriétés diélectriques.

12. Procédé selon l'une quelconque des revendications précédentes,
dans lequel on ajuste les conditions de croissance pour la croissance de la couche de matériau de masque de manière que la croissance tridimensionnelle soit prépondérante et que la couche de matériau de masque soit constituée de façon prépondérante d'une pluralité de cristallites à croissance tridimensionnelle.

13. Procédé selon l'une quelconque des revendications 1 à 11,
dans lequel on ajuste les conditions de croissance pour la croissance de la couche de matériau de masque de manière que la croissance bidimensionnelle soit prépondérante et que la couche de matériau de masque soit formée de façon prépondérante à partir d'une pluralité de couches partielles se réunissant par croissance bidimensionnelle.

14. Procédé selon l'une quelconque des revendications précédentes,
dans lequel on ajuste les conditions de croissance pour la croissance de la couche de matériau de masque de manière que la plupart des fenêtres soient formées avec une extension moyenne dans l'ordre de grandeur de micromètres.

15. Procédé selon l'une quelconque des revendications 1 à 13,
dans lequel on ajuste les conditions de croissance pour la croissance de la couche de matériau de masque de manière que la plupart des fenêtres soient formées avec une extension moyenne inférieure ou égale à 1 µm.

16. Procédé selon l'une quelconque des revendications précédentes,
dans lequel on ajuste et/ou fait varier pendant la croissance les conditions de croissance pour la croissance des couches de semi-conducteur de manière que les couches de semi-conducteur des éléments structuraux acquièrent au moins approximativement une forme lenticulaire.

17. Procédé selon l'une quelconque des revendications précédentes,
dans lequel la croissance de la couche de matériau de masque et des couches de semi-conducteur s'effectue au moyen d'épitaxie en phase gazeuse aux organométalliques.

18. Puce optoélectronique à semi-conducteur, comprenant
un substrat et une surface de croissance comportant une couche de matériau de masque, la puce à semi-conducteur comportant une pluralité d'éléments structuraux disposés les uns à côté des autres, qui sont disposés sur des zones de la surface de croissance qui se trouvent à l'intérieur des fenêtres, les éléments structuraux étant constitués chacun par une succession de couches de semi-conducteur qui comporte une zone active émettant un rayonnement électromagnétique,
**caractérisée en ce que**
la couche de matériau de masque présente plusieurs fenêtres ayant des formes et/ou des surfaces d'ouverture variables, réparties statistiquement.
